(19)

**Europäisches Patentamt**
**European Patent Office**
**Office européen des brevets**

(11) **EP 4 579 311 A1**

(12) **EUROPEAN PATENT APPLICATION**
published in accordance with Art. 153(4) EPC

(43) Date of publication:
**02.07.2025 Bulletin 2025/27**

(21) Application number: **23879525.6**

(22) Date of filing: **19.09.2023**

(51) International Patent Classification (IPC):
***G02B 26/10*** (2006.01)    ***B81B 3/00*** (2006.01)
***G02B 26/08*** (2006.01)    ***H10N 30/20*** (2023.01)

(52) Cooperative Patent Classification (CPC):
**G02B 26/0858; B81B 3/00; G02B 26/08;**
**G02B 26/10; G02B 26/105; H10N 30/20**

(86) International application number:
**PCT/JP2023/033853**

(87) International publication number:
**WO 2024/084875 (25.04.2024 Gazette 2024/17)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **20.10.2022 JP 2022168099**

(71) Applicant: **Stanley Electric Co. Ltd.**
**Tokyo 153-8636 (JP)**

(72) Inventor: **TANAKA, Haruki**
**Tokyo 153-8636 (JP)**

(74) Representative: **Carstens, Dirk Wilhelm**
**Wagner & Geyer Partnerschaft mbB**
**Patent- und Rechtsanwälte**
**Gewürzmühlstraße 5**
**80538 München (DE)**

(54) **LIGHT DEFLECTOR**

(57)     A light deflector 10 includes a mirror portion 11, torsion bars 12a and 12b extending from each side of the mirror portion 11 along a rotation axis Da, inner actuators 13a and 13b coupling to outer coupling regions 36 of the torsion bars 12a and 12b from both sides and reciprocally rotating the torsion bars 12a and 12b around the rotation axis Da, and a slit 20a and a slit 20b formed in the torsion bars 12a and 12b having closed both ends and extending along the rotation axis Da over a length range that reaches an inner coupling region 38 and an outer coupling region 36.

FIG.2A

**Description**

Technical Field

The present invention relates to a light deflector that is equipped in a scanning device and emits scanning light.

Background Art

A light deflector manufactured as a micro electro mechanical systems (MEMS) device reflects an incident laser beam onto a mirror portion that reciprocally rotates around a rotation axis, and emits reflected light as scanning light from the mirror portion (for example, Patent Literatures 1 to 3).

The light deflector of Patent Literature 1 includes a mirror portion, a pair of torsion bars that are provided one on each side of the mirror portion in an extending direction of a rotation axis of the mirror portion and that extend from the mirror portion along the rotation axis, and a piezoelectric actuator that is coupled to a distal end-side end portion of each torsion bar and reciprocally rotates the torsion bar around the rotation axis.

The light deflector of Patent Literature 2 includes a mirror portion, four torsion bars in total of which two are provided on each side of the mirror portion in an extending direction of a rotation axis of the mirror portion, and which extend parallel to each other along the rotation axis with gaps having an equal width interposed therebetween, and a piezoelectric actuator that is coupled to a distal end-side end portion of each of the torsion bars to reciprocally rotate the torsion bar around the rotation axis.

The light deflector of Patent Literature 3 includes a mirror portion, four torsion bars in total of which two are provided on each side of the mirror portion in an extending direction of a rotation, respectively, and which are hole-machined (that is, in a tapered shape) such that a gap between the two torsion bars is narrowed toward a distal end side that is largely separated, and an electrostatic actuator that reciprocally rotates the mirror portion around the rotation axis from both sides in a direction perpendicular to the rotation axis.

Citation List

Patent Literatures

Patent Literature 1: Japanese Patent Application Laid-Open No. 2009-169290
Patent Literature 2: Japanese Patent Application Laid-Open No. 2016-151681
Patent Literature 3: Japanese Patent No. 3905539

Summary of Invention

Technical Problem

It is desirable that the light deflector has a large scanning angle corresponding to a reciprocating rotation angle of the mirror portion around the rotation axis. On the other hand, a maximum reciprocating rotation angle of the mirror portion is limited by a maximum allowable stress of the torsion bar so that the torsion bar is not damaged during the reciprocating rotation.

When a direction view of the mirror portion as viewed from a thickness direction is defined as a front view, a ratio of a width of the torsion bar to a thickness of the torsion bar in the front view is defined as an aspect ratio (A.R.). A location where the maximum stress is generated in the torsion bar, that is, a location that is most likely to be damaged as the torsion bar reciprocally rotates, is a location on the rotation axis in the front view of the torsion bar when A.R. > 1. In addition, when A.R. < 1, a corner portion is provided as a portion farthest from the rotation axis in a cross section of the torsion bar.

The light deflector of Patent Literature 1 is A.R. < 1, and locations of the maximum stress of the mirror portion are four corners of the cross section of the mirror portion. In order to increase the maximum reciprocating rotation angle of the mirror portion with this structure, the only solution is to narrow the width of the torsion bar or to reduce the thickness thereof. The decrease in the width and the thickness of the torsion bar increases harmonics generated in the mirror portion, which causes abnormal oscillation (oscillation in the extending direction of the rotation axis or in a perpendicular direction to the rotation axis, or the like) in the mirror portion.

In Patent Literature 2, since the two torsion bars on each side with respect to the mirror portion are completely opened by a gap extending in the width direction at an end on a side opposite to the mirror portion, a transmission efficiency of a rotation force transmitted from the piezoelectric actuator to the torsion bar is lowered.

In the light deflector of Patent Literature 3, since coupling points where the two torsion bars on each side of the mirror portion are coupled to the mirror portion are two coupling points separated from each other with respect to the rotation axis in the perpendicular direction, a rotation drive force of the torsion bars or an inversion drive force for reversing the rotation is increased, and a load of the actuator is increased, as compared with a case of one coupling point.

An object of the present invention is to provide a light deflector that can increase a maximum allowable rotation angle of a torsion bar by overcoming the above-described problem of the related technique in a case where an aspect ratio A.R. of the torsion bar is A.R. < 1.

Solution to Problem

A light deflector of the present invention including:

a mirror portion having a mirror surface on one side in a thickness direction and configured to reciprocally rotate around a rotation axis (Da) perpendicular to the thickness direction;

a pair of torsion bars configured to extend along the rotation axis from inner coupling positions of both ends of the mirror portion in an extending direction of the rotation axis;

actuators coupling to the torsion bars from both sides in a width direction at an outer coupling position apart from the inner coupling position in the extending direction and reciprocally rotating the torsion bars around the rotation axis at the outer coupling position; and

slits formed in the torsion bars such that both ends in the extending direction are closed in a front view as a direction view when the mirror surface is viewed from the one side in the thickness direction and the slits extend along the rotation axis in a length range in which the both ends reach the inner coupling position and the outer coupling position, in which

a dimension of the torsion bar between both ends in the front view is Wa, and a thickness in the front view is Ta,

a width of the slit in the front view is Wb, and

$(Wa - Wb)/Ta < 1$ is satisfied.

Effect of the Invention

According to the present invention, in the light deflector in which an aspect ratio A.R. of the torsion bar is A.R. < 1, the slits are formed in the torsion bars such that both ends in the extending direction are closed in the front view and the slits extend along the rotation axis over length range that reaches the inner coupling region and the outer coupling region at both ends. Accordingly, the stress applied to each torsion bar during the reciprocating rotation around the rotation axis is dispersed to four of the side surfaces of the torsion bar and the inner surfaces of the slit. Therefore, the reciprocating rotation angle when the maximum allowable stress is generated in the torsion bar can be increased.

Brief Description of Drawings

FIG. 1 is a schematic view of a light deflector as viewed from an oblique front side of a front surface.

FIG. 2A is an enlarged front view of a range including a torsion bar and a periphery thereof in FIG. 1.

FIG. 2B is an enlarged view of a range of an outer coupling region of FIG. 2A.

FIG. 2C is an enlarged view of a range of an inner coupling region of FIG. 2A.

FIG. 3A is a front view illustrating a range in which an inner expansion portion having a shape different from an inner expansion portion of FIG. 2A is provided, together with inner end portions of the torsion bars on both sides thereof.

FIG. 3B is an enlarged view of the inner coupling region of FIG. 3A.

FIG. 4 is a cross-sectional view which is cut in a thickness direction of the light deflector along an axis Ax of FIG. 1 in a stationary state of the mirror portion.

FIG. 5 is a cross-sectional view which is cut along a plane parallel to the cross section of FIG. 4 at a position of an equal-width extension portion of the torsion bar.

FIG. 6 is a description view of an aspect ratio of the torsion bar.

FIG. 7 is a stress distribution view around a slit when the slit is configured of only the equal-width extension portion.

Description of Embodiments

Hereinafter, embodiments of the present invention will be described. The present invention includes various modified configurations of the embodiments within the range of design matters of those skilled in the art. Configuration elements common to a plurality of embodiments are denoted by the same reference numerals throughout all the drawings.

(Light Deflector/Entirety)

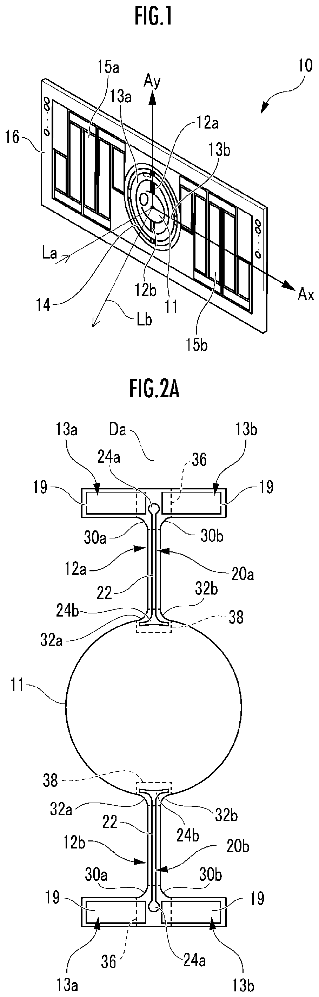

FIG. 1 is a schematic view of a light deflector 10 as viewed from an oblique front side of a front surface. The light deflector 10 is manufactured from a SOI substrate as a micro electro mechanical systems (MEMS) device. For convenience of description, a direction view as viewed from an incident side (mirror surface side of a mirror portion 11 in a thickness direction) of an incidence light La in a thickness direction (also the thickness direction of the mirror portion 11) of the light deflector 10 will be referred to as "front view".

A description of an overall configuration of a light deflector 10 will be schematically made with reference to FIG. 1. Details of an overall configuration of the light deflector 10 are described in, for example, Japanese Patent Application Laid-Open No. 2012-201386 filed by the present applicant.

The light deflector 10 is equipped in any device equipped as a light scanner, for example, a projector (also including a pico projector), a head-up display, an automobile headlamp, an eyewear.

The light deflector 10 has a left-right symmetrical structure in a front view, and includes the mirror portion 11, up and down torsion bars 12a and 12b, left and right inner actuators 13a and 13b, a movable frame 14, left and right outer actuators 15a and 15b, and a fixation frame 16. The inner actuators 13a and 13b, and the outer actuators 15a and 15b are all piezoelectric actuators.

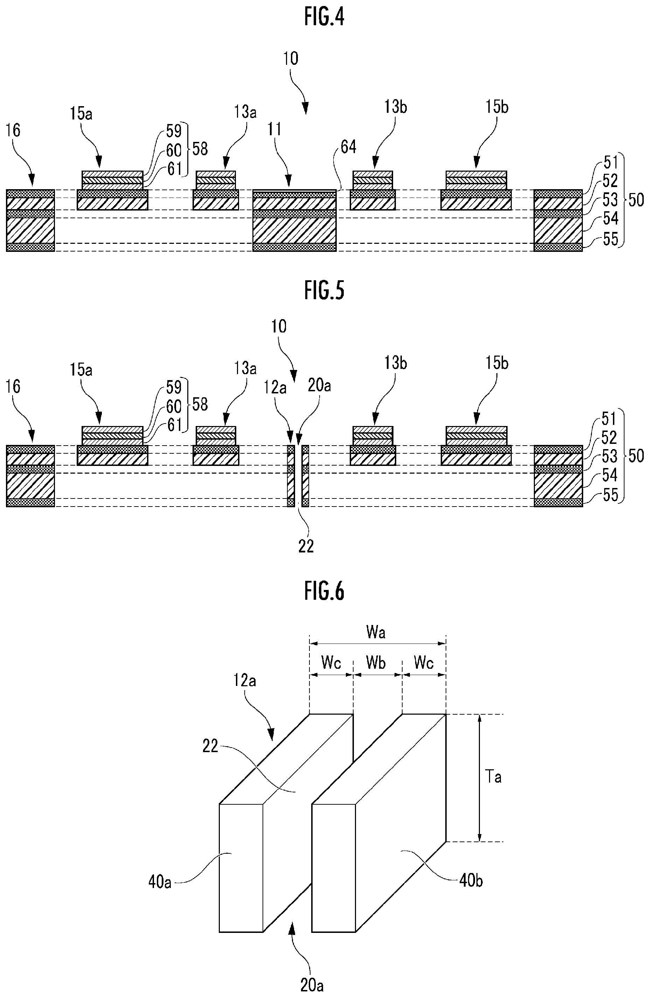

For convenience of description of the configuration of the light deflector 10, axes Ax and Ay orthogonal to each other at a center O of the mirror portion 11 are defined. The axes Ax and Ay are defined as coordinate axes parallel to a mirror surface (reflective film 64 in FIG. 4) of the mirror portion 11, and are also two rotation axes of the mirror portion 11 that are orthogonal to each other. In addition, in the light deflector 10, a portion close to the center O and a portion far from the center O will be referred to as an inner side and an outer side, respectively.

The circular mirror portion 11 has the reflective film 64 (FIG. 4) that acts as the mirror surface on a front surface side (one side of the mirror portion 11 in the thickness direction). The incidence light La is emitted from a laser light source (not illustrated), is incident on the mirror portion 11, is reflected from the mirror portion 11, and is emitted from the mirror portion 11 as a scanning light Lb.

The torsion bars 12a and 12b extend along the axis Ay and mutually couple the mirror portion 11 and the movable frame 14. The inner actuators 13a and 13b have a shape of a peripheral contour of an ellipse that is vertically long in a front view of the entirety mutually coupled from the left and right, and each thereof has a shape of an elliptical arc of a semi-ellipse of the left and right.

In the example of FIG. 1, the torsion bars 12a and 12b extend from the mirror portion 11, exceed the coupling portions with the inner actuators 13a and 13b, reach the movable frame 14, and are coupled to an inner periphery of the movable frame 14. However, the torsion bars 12a and 12b may be configured to remain at positions of the coupling portions with the inner actuators 13a and 13b without reaching the inner periphery of the movable frame 14.

The movable frame 14 has a vertically long elliptical contour shape similar to an entire shape in which the left and right inner actuators 13a and 13b are mutually coupled in a front view, and surrounds the mirror portion 11, the torsion bars 12a and 12b, and the inner actuators 13a and 13b from the outside. The inner actuators 13a and 13b are interposed between the torsion bars 12a and 12b, and the movable frame 14.

Drive voltages having sinusoidal waveforms of a resonance frequency Fy in mutually opposite phases are supplied to the inner actuators 13a and 13b from a drive device (not illustrated), and the torsion bars 12a and 12b are reciprocally rotated around the axis Ay at the resonance frequency Fy.

The outer actuators 15a and 15b are disposed on the left and right of the movable frame 14 and are interposed between an outer periphery of the movable frame 14 and an inner periphery of the fixation frame 16. The outer actuators 15a and 15b are configured of a plurality of linear piezoelectric cantilevers that is coupled in series in a meander pattern. In the outer actuators 15a and 15b, when numbering in order from the outside to the inside in a lateral direction (direction parallel to a long side of the rectangular fixation frame 16), odd-numbered piezoelectric cantilevers and even-numbered piezoelectric cantilevers are supplied with drive voltages of a sawtooth wave or a triangular wave having non-resonance frequencies Fx (Fx < Fy) that have mutually opposite phases with each other from a control device (not illustrated). Accordingly, the outer actuators 15a and 15b reciprocally rotate the movable frame 14 around a rotation axis (different from the axis Ax) in the lateral direction.

A schematic operation of the entire light deflector 10 will be described.

During the operation of the light deflector 10, the drive voltage is supplied from the drive device (not illustrated) to the torsion bar 12 (general term for the torsion bars 12a and 12b) and the outer actuator 15 (general term for the outer actuators 15a and 15b). Accordingly, the mirror portion 11 reciprocally rotates around the axes Ax and Ay at the non-resonance frequency Fx and the resonance frequency Fy, respectively. Fx and Fy are, for example, 60 Hz and 25 kHz, respectively.

On the other hand, the incidence light La of the laser beam from the laser light source (not illustrated) is incident on the mirror portion 11 that reciprocally rotates around the axes Ax and Ay. As a result, the scanning light Lb as the reflected light of the incidence light La is emitted from the mirror portion 11 as a two-dimensional scanning beam.

The incidence light La may be three laser beams of colors different from red, green, and blue, or may be a predetermined single color. A light source control device (not illustrated) can control brightness (strength) of the incidence light La emitted from the laser light source for each color.

(Configuration of Slit of Embodiment)

FIG. 2A is an enlarged front view of a range including the torsion bars 12a and 12b and a periphery thereof in FIG. 1. Da is a rotation axis of the mirror portion 11 in a longitudinal direction, and extends on the axis Ay in FIG. 1. In the drawings from FIG. 2A, outer ends (ends far from the center O) of the torsion bars 12a and 12b remain at the inner actuators 13a and 13b without reaching the inner periphery of the movable frame 14.

Slits 20a and 20b are formed in the torsion bars 12a and 12b, respectively. In a range including the mirror portion 11, the torsion bars 12a and 12b, and the inner actuators 13a and 13b, the structure is vertically symmetrical with respect to the axis Ax (FIG. 1) in a front view. Therefore, the configuration and operation of the upper torsion bar 12a and the slit 20a will be described, and the configuration and operation of the lower torsion bar 12b and the slit 20b will not be described.

In FIG. 2A, the slit 20a is formed in the torsion bar 12a so as to extend along the rotation axis Da and to penetrate in the thickness direction. The slit 20a has an equal-width extension portion 22 that extends along the rotation axis Da with an equal width, and an outer expansion end portion 24a and an inner expansion end portion 24b that are consecutively provided at an outer end and an inner end of the equal-width extension portion 22, respectively.

A circumference line of the mirror portion 11 disappears at the coupling portion between the mirror portion 11 and the torsion bar 12a. When a boundary line between the mirror portion 11 and the torsion bar 12a is set on the circumference line where the boundary line disappears, the equal-width extension portion 22 of the slit 20 reaches at least the boundary line toward the inside and typically enters the inside of the mirror portion 11 beyond the boundary line. The boundary line means the coupling position between the mirror portion 11 and the torsion bar 12a.

The torsion bar 12a and the inner actuators 13a and 13b are mutually coupled in an outer coupling region 36. The outer coupling region 36 is defined as a region inside an outer peripheral contour of the inner actuators 13a and 13b in the extending direction, which is a region inside a left end and a right end of each of left and right curve-shaped outer corner portions (first corner portions) 30a and 30b in a width direction and outside the ends of the left and right curve-shaped outer corner portions 30a and 30b in the extending direction on a center O side. The entire outer coupling region 36 means the coupling position between the torsion bar 12a and the mirror portion 11.

The mirror portion 11 and the torsion bar 12a are mutually coupled in an inner coupling region 38. The inner coupling region 38 is defined as a region inside a left end and a right end of left and right curve-shaped inner corner portions 32a and 32b (second corner portions) in the width direction, on the center O side from ends of the left and right curve-shaped inner corner portions 32a and 32b farther from the center O in the extending direction. Further, the inner coupling region 38 is defined as a region in which a predetermined stress is generated during the reciprocating rotation of the mirror portion 11 around the rotation axis Da in the mirror portion 11. The entire inner coupling region 38 means the coupling position between the torsion bar 12a and the mirror portion 11.

The curve-shaped outer corner portions 30a and 30b are formed as first curve lines that spread outside from a side edge of the torsion bar 12a in the width direction of the torsion bar 12a (direction perpendicular to the extending direction of the rotation axis Da and the thickness direction) at the corner portion between the side edge of the torsion bar 12a and an inner peripheral edge of the inner actuators 13a and 13b, and that are convex curves toward the inside of the outer coupling region 36. The curve-shaped inner corner portions (second corner portions) 32a and 32b are formed as second curve lines that spread outside from the side edge of the torsion bar 12a in the width direction at the corner portion between the peripheral edge of the mirror portion 11 and the side edge of the torsion bar 12a, and that are convex curves toward the inside of the inner coupling region 38.

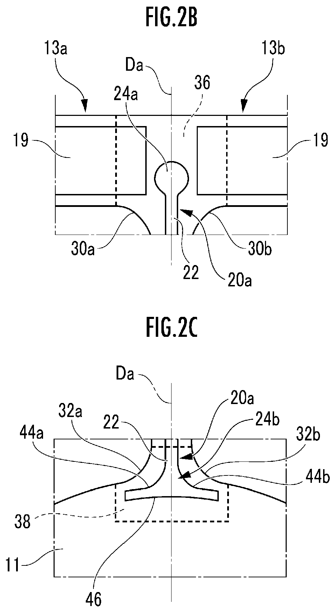

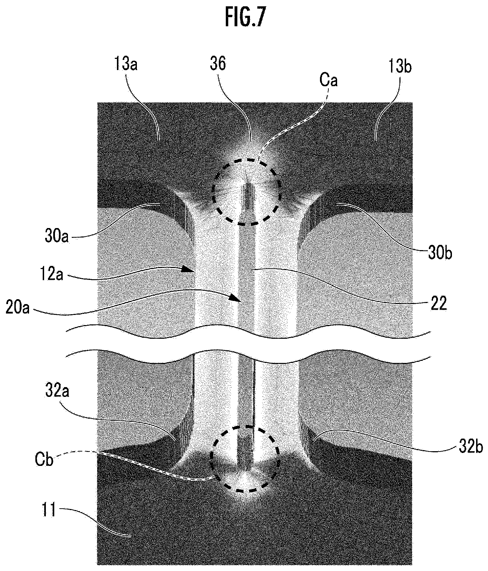

FIGS. 2B and 2C are enlarged views of a range of the outer coupling region 36 and the inner coupling region 38 of FIG. 2A, respectively. An outer expansion end portion 24a and an inner expansion end portion 24b of the slit 20a are formed in the outer coupling region 36 and the inner coupling region 38, respectively. The stress relaxation as the effects of the outer expansion end portion 24a and the inner expansion end portion 24b will be described in detail in FIG. 7 described later. Here, only the configurations of the outer expansion end portion 24a and the inner expansion end portion 24b will be described with reference to FIGS. 2B and 2C.

In FIG. 2B, in a front view, the outer expansion end portion 24a is a circular shape (an example of a first curved contour shape) except for a boundary portion between the outer expansion end portion 24a and the equal-width extension portion 22. On the other hand, the contour line of the boundary portion is set to a contour line that extends in parallel with the first curve lines of the curve-shaped outer corner portions 30a and 30b with substantially equal widths.

A diameter of the outer expansion end portion 24a is larger than a width (Wb in FIG. 6 described later) of the equal-width extension portion 22, and the outer expansion end portion 24a is wider than the equal-width extension portion 22 in the width direction of the slit 20a. The curve-shaped outer corner portions 30a and 30b have significance in reinforcement against the expansion of the outer expansion end portion 24a in the width direction.

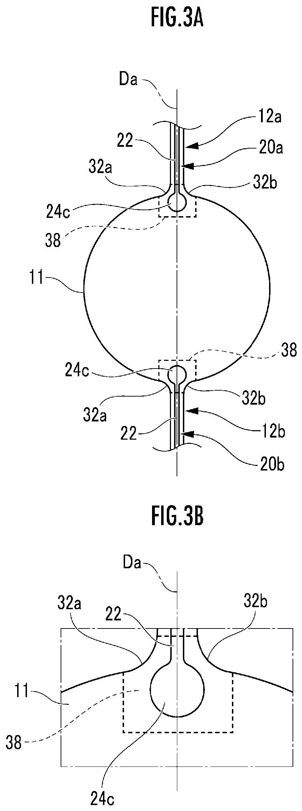

In FIG. 2C, the inner expansion end portion 24b is formed in a shape (an example of a second curved contour shape) that is left-right symmetrical with respect to the rotation axis Da in a front view. The inner expansion end portion 24b is formed as a through-hole defined by the outer curved contour portions 44a and 44b close to the peripheral edge of the mirror portion 11 and the inner curved contour portion 46 close to the center O. The outer curved contour portions 44a and 44b are set to contour lines that are parallel to each other with substantially equal widths from the second curve lines of the curve-shaped inner corner portions 32a and 32b. The significance of the contour line of the inner expansion end portion 24b will be described later in comparison with an inner expansion end portion 24c of a columnar hole of FIGS. 3A and 3C.

The inner curved contour portion 46 is set on a contour line of a circular arc concentric with the circle of the mirror portion 11. A width of the inner expansion end portion 24b is larger than the width of the equal-width extension portion 22, and the inner expansion end portion 24b is wider than the equal-width extension portion 22 in the width direction of the slit 20a. The curve-shaped inner corner portions 32a and 32b have significance in reinforcement against the expansion of the inner expansion end portion 24b in the width direction.

FIG. 3A is a front view of a range including the mirror portion 11 and the inner end portions of the torsion bars 12a and 12b in the extending direction of the rotation axis Da. FIG. 3B is a view illustrating an enlarged portion of the inner coupling region 38. The inner expansion end portion 24c has the same columnar hole shape (another example of the second curved contour shape) as the outer expansion end portion 24a, and is formed to penetrate the mirror portion 11 with left-right symmetrical with respect to the rotation axis Da in the inner coupling region 38. A boundary portion between the equal-width extension portion 22 and the inner expansion end portion 24c is set to a contour line extending in parallel with the second curve line.

The diameter of the inner expansion end portion 24c is larger than the width of the equal-width extension portion 22, and the inner expansion end portion 24c is wider than the equal-width extension portion 22 in the width direction of the slit 20a. The curve-shaped outer corner portions 30a and 30b have significance of reinforcement against the expansion of the inner expansion end portion 24c in the width direction.

(Cross-sectional Structure)

FIG. 4 is a cross-sectional view which is cut in the thickness direction of the light deflector 10 along the axis Ax of FIG. 1 in a stationary state of the mirror portion 11, and FIG. 5 is a cross-sectional view which is cut along a plane parallel to the cross section of FIG. 4 at the position of the equal-width extension portion 22 of the torsion bar 12a.

In FIGS. 4 and 5, an SOI substrate 50 has a laminated structure of five layers of an oxide film layer 51, an active layer 52, an oxide film layer 53, a handling layer 54, and an oxide film layer 55 in this order from the top. The oxide film layers 51, 53, and 55 contain $SiO_2$ as a component. The active layer 52 and the handling layer 54 contain Si as a component. A piezoelectric element 58 has a laminated structure of three layers of an upper electrode layer 59, a lead zirconate titanate (PZT) film layer 60, and a lower electrode layer 61 in this order from the top.

The mirror portion 11, the torsion bar 12a, and the fixation frame 16 are configured of all the layers of the SOI substrate 50. On the other hand, the inner actuators 13a and 13b, and the outer actuators 15a and 15b are configured of a three-layer laminate of the two layers of the oxide film layers 51 and the active layer 52 from the top of the SOI substrate 50, and the piezoelectric elements 58 laminated thereon. The mirror portion 11 is coated with the reflective film 64 of a metal component on the surface. The reflective film 64 has a role of a mirror surface that reflects the incidence light La (FIG. 1).

In FIG. 5, the equal-width extension portion 22 of the slit 20a penetrates the torsion bar 12a in the thickness direction. Although not illustrated, the outer expansion end portion 24a and the inner expansion end portion 24b of the slit 20a also penetrate the outer expansion end portion 24a of the torsion bar 12a and the inner expansion end portion 24b of the mirror portion 11 in the thickness direction, similarly to the equal-width extension portion 22.

The slit 20a in the torsion bar 12a is manufactured by deep reactive ion etching (deep RIE). As a typical deep RIE method, there is a method of cooling a sample to a low temperature using a high-density plasma, a method of using an etching technique called a Bosch process, and a method of using both thereof.

Although not illustrated, a laminated structure of a cross section of the outer coupling region 36 will be described. In the outer coupling region 36, the upper electrode layer 59 and the PZT film layer 60 on the upper side in the three-layer laminate of the piezoelectric element 58 are removed by etching, and only the lowermost lower electrode layer 61 remains without being removed. The lower electrode layer 61 is a layer of an earth voltage, and as a result of the residual lower electrode layer 61 in the outer coupling region 36, the lower electrode layers 61 of the left and right inner actuators 13a and 13b are in a state of electrically connected to each other in the outer coupling region 36. On the other hand, since the left and right inner actuators 13a and 13b are separated from each other in the outer coupling region 36 in the upper electrode layer 59 and the PZT film layer 60, the left and right inner actuators 13a and 13b are individually supplied with a drive voltage and can be driven individually.

(Aspect Ratio)

FIG. 6 is a description view of an aspect ratio A.R. of the torsion bar 12a. In FIG. 6, the definitions of the respective reference numerals are as follows.

Wa: both end width of torsion bar 12a in a front view
Wb: width of equal-width extension portion 22 in a front view
Wc: width of left and right portions of torsion bar 12a divided in left and right by equal-width extension portion 22 in a front view
Ta: thickness of torsion bar 12a

As is clear from FIG. 6, the following Expression (1) is satisfied.

$$(1)\ \text{Expression: } Wa = Wb + 2 \cdot Wc$$

In the present invention, the setting is performed as in the following Expression (2).

(2) Expression: (Wa - Wb)/Ta < 1

In the light deflector 10 of the embodiment, it is preferable to set the dimensions as in the following Expressions (3) to (6) from the viewpoint of suppressing harmonics.

(3) Expression: $0.1 \leq$ (Wa - Wb)

(4) Expression: Wb = Wc

(5) Expression: Wa/Ta < 1

(6) Expression: Wb $\leq$ 2·Wc

The significance of Expression (5) is that, although the slits 20a and 20b are originally formed to prevent damage to the corners of the cross section of the torsion bars 12a and 12b, when Wa/Ta $\geq$ 1, damage may occur earlier on the rotation axis of the torsion bars 12a and 12b, and thus the significance of the formation of the slits 20a and 20b may be lost. The significance of Expression (6) is that, when Wb > 2·Wc is satisfied, the shake (pumping) of the mirror portion 11 in the extending direction of the rotation axis Da is dominant. In addition, it is advantageous that Wb is 25 $\mu$m or more.

The two torsion bars facing each other in the width direction in Patent Literature 3 are not referred to as slits according to the present invention because the holes of a tapered shape are formed and the torsion bars are too far apart from each other, but are included in Wb > 2·Wc in terms of numerical expression. Therefore, the rotation drive force of the torsion bar or the inversion drive force for reversing the rotation is increased, and the load of the actuator is increased.

In addition, in a case where the aspect ratio of the torsion bar before forming the slit 20a is Wa/Ta = (Wa + 2·Wc)/Ta < 1, stress is applied to the torsion bar during the reciprocating rotation around the rotation axis, but the stress can be relaxed by providing the slit of the present invention in the torsion bar.

(Effects of Equal-width Extension Portion)

The effects of the torsion bar 12 (general term for the torsion bars 12a and 12b) will be described. First, the effects of the configuration in which the slit 20 has only the intermediate equal-width extension portion 22 without the outer expansion end portion 24a and the inner expansion end portion 24b at both ends will be described.

As a result, the torsion bar 12 has the slit 20 (general term for the slits 20a and 20b) with the equal-width extension portion 22, and thus the total area of the side surfaces is the sum of the area of the outer side surface in the width direction and the area of the inner surface of the slit 20 as the inner side surface. As a result, the area of the side surface increases, and the stress applied to the side surface is dispersed. This leads to a decrease in stress in the torsion bar 12, and the maximum allowable rotation angle for damage resistance of the torsion bar 12 around the rotation axis Da increases. In this way, the lateral scanning angle of the scanning light Lb around the rotation axis Da increases.

In the calculation of the inventor, the unit rotation angle (unit deflection angle: Mpa/deg) of the torsion bar 12 around the rotation axis Da was reduced by 25% due to the stress dispersion effect of the inner surface of the slit 20. This means that a limit deflection angle of the torsion bar 12 around the rotation axis Da is 1.33 times.

(Stress Relaxation Structure)

FIG. 7 is a stress distribution view around the slit 20a when the slits 20a and 20b of the light deflector 10 are configured of only the equal-width extension portion 22 without having the outer expansion end portion 24a and the inner expansion end portions 24b and 24c. FIG. 7 illustrates a screen display based on an analysis result of a simulation, and illustrates that the stress increases from a dark portion to a light portion.

In a case where the outer expansion end portion 24a and the inner expansion end portion 24b are omitted in the slits 20a and 20b and only the equal-width extension portion 22 is formed, the maximum stress point appears at both ends of the equal-width extension portion 22. Black broken line circles Ca and Cb are illustrated as circles centered on the outer end and the inner end of the equal-width extension portion 22 of the slit 20a. It can be seen that the region where the stress is large spreads outward and inward, respectively from the outer end and the inner end of the equal-width extension portion 22 in the extending direction of the equal-width extension portion 22.

The position of the inner coupling region 38 will be described with reference to FIG. 7. As described above, the circumference line of the mirror portion 11 disappears at the coupling portion between the mirror portion 11 and the torsion bar 12a. When the boundary line between the mirror portion 11 and the torsion bar 12a is set on the circumference line where the boundary line disappears, the inner coupling region 38 is set as a region where a predetermined value or more of stress is generated in the mirror portion 11 on the mirror portion 11 side with respect to the boundary line.

In the light deflector 10, the outer expansion end portion 24a and the inner expansion end portion 24b, or the inner expansion end portion 24c are consecutively provided respectively at both ends of the equal-width extension portion 22 such that the maximum stress in the torsion bars 12a and 12b is equal to or less than a predetermined upper limit.

The stress transmitted from the mirror portion 11 in the outside direction along the rotation axis Da in the torsion bars 12a and 12b is divided into left and right portions of the torsion bars 12a and 12b on both sides of the slit 20 in the width direction and is transmitted in parallel with the outer coupling region 36. The circular shape of the outer expansion end portion 24a in the front view has an effect of appropriately dispersing in the left and right the stress that is divided into the left and right, and transmitted in parallel, thereby homogenizing the stress in the outer coupling region 36 and reducing the maximum stress. The reduction in the maximum stress leads to an increase in a maximum allowable reciprocation angle of the mirror portion 11 around the rotation axis Da.

The effects of the inner expansion end portion 24c will be described before the inner expansion end portion 24b. The effects of the inner expansion end portion 24c are the same as the effects of the outer expansion end portion 24a. That is, in the mirror portion 11, the stress transmitted from the torsion bars 12a and 12b in the inner direction along the rotation axis Da is divided into left and right portions of the torsion bars 12a and 12b on both sides of the slit 20 in the width direction and is transmitted in parallel with the mirror portion 11. The circular shape of the inner expansion end portion 24c in the front view has an effect of appropriately dispersing in the left and right the stress that is divided into the left and right, and transmitted in parallel, thereby homogenizing the stress in the inner coupling region 38 and reducing the maximum stress, similarly to the outer expansion end portion 24a. Since the inner expansion end portion 24c has a simpler shape than the inner expansion end portion 24b, there is an advantage that the manufacturing cost is low.

In order to reduce the maximum stress in the outer coupling region 36 and the inner coupling region 38, in some cases, it may be advantageous to slightly move the outer end and/or the inner end of the slit 20 to the outside and the inside along the rotation axis Da from that illustrated in FIG. 7, respectively and then consecutively provide the outer expansion end portion 24a and the inner expansion end portions 24b and 24c. In such a case, the outer end and/or the inner end of the slit 20 is not fixed to the portion illustrated in FIG. 7, and the positions of the outer expansion end portion 24a and the inner expansion end portions 24b and 24c are set after the outer end and/or the inner end thereof are appropriately allowed to deeply enter the outer coupling region 36 and the inner coupling region 38 along the rotation axis Da, respectively.

Next, the advantages of the inner expansion end portion 24b with respect to the inner expansion end portion 24c will be described. The inner end of the inner expansion end portion 24b is located outside the inner end of the inner expansion end portion 24c in the extending direction of the rotation axis Da. This means that the entire surface of the mirror portion 11 of which the beam cross section of the incidence light La is a substantially circular shape is irradiated.

In the inner expansion end portion 24c (FIGS. 3A and 3B), the closest point to the center O is deeply penetrated into the center O in the mirror portion 11. This means that an effective diameter of the mirror portion 11 in the extending direction of the rotation axis Da is reduced, which causes a decrease in resolution of an image generated by the scanning light Lb in an irradiation region such as a screen. On the other hand, the inner expansion end portion 24b is formed along a circumference contour of the mirror portion 11, and the closest point to the center O can be sufficiently separated from the inner expansion end portion 24c. Therefore, the torsion bar 12a relaxes the stress at the inner ends of the torsion bars 12a and 12b while minimizing the decrease in the effective diameter of the mirror portion 11. Accordingly, it is possible to increase the reciprocating rotation angle of the mirror portion 11 around the rotation axis Da while avoiding the decrease in the effective diameter of the mirror portion 11.

In the light deflector of Patent Literature 2 described above, instead of one, two torsion bars are provided on each side of the mirror portion. That is, a gap is formed between the two torsion bars, and the gap is closed on the inner side, that is, the mirror portion side, but is open on the outer side, that is, the opposite side of the mirror portion without being closed. This means that two torsion bars are provided on each side of the mirror portion.

On the other hand, in the light deflector 10, since the slits 20a and 20b are closed at both ends in the extending direction of the rotation axis, the torsion bars 12a and 12b in which the slits 20a and 20b are formed on the inner peripheral side are not separated into two respectively, and maintain one torsion bar, and the light deflector 10 is configured to include only one torsion bar on each side of the mirror portion 11. As a result, the transmission efficiency of the force from the inner actuators 13a and 13b to the torsion bars 12a and 12b in the light deflector 10 is higher than that in the configuration of two torsion bars on each side of the light deflector of Patent Literature 2, and according to the calculation of the present inventor, the drive efficiency of the mirror portion 11 around the rotation axis Da was improved by 29%.

(Modified Examples)

The light deflector 10 is a biaxial scanning type light deflector. However, the light deflector of the present invention may be a uniaxial scanning type light deflector as long as the actuator includes a configuration of reciprocally rotating the mirror portion around the rotation axis through the torsion bar.

The outer expansion end portion 24a and the inner expansion end portion 24c of the slits 20a and 20b have a substantially circular shape in a front view. However, the outer end portion and the inner end portion of the slit of the present invention may be through-holes of which front views are regular polygons (for example:

regular triangles, regular squares, regular pentagons, and the like) that are left-right symmetrical with respect to the rotation axis Da in a front view.

In the light deflector 10, the equal-width extension portion 22 is described as having an equal width, but in the present invention, the extension portion of the formation location of the equal-width extension portion 22 of the light deflector 10 may not be the equal-width extension portion over the entire length in a front view. For example, the both ends of the extension portion may have the same width in a front view to the extent that the driving force of the inner actuators 13a and 13b does not significantly increase, the width of the middle portion may be widened or narrowed, and the widths of the both ends of the extension portion may be different from each other.

Description of Reference Numerals

10: light deflector
11: mirror portion
12a, 12b: torsion bar
13a, 13b: inner actuator
14: movable frame
20a, 20b: slit
22: equal-width extension portion
24a: outer expansion end portion (outer end portion)
24b, 24c: inner expansion end portion (inner end portion)
30a, 30b: curve-shaped outer corner portion (first corner portion)
32a, 32b: curve-shaped inner corner portion (second corner portion)
36: outer coupling region
38: inner coupling region
44: outer curved contour portion
46: inner curved contour portion
Da: rotation axis.

**Claims**

1. Alight deflector comprising:

a mirror portion having a mirror surface on one side in a thickness direction and configured to reciprocally rotate around a rotation axis (Da) perpendicular to the thickness direction;
a pair of torsion bars configured to extend along the rotation axis from inner coupling positions of both ends of the mirror portion in an extending direction of the rotation axis;
actuators coupling to the torsion bars from both sides in a width direction at an outer coupling position apart from the inner coupling position in the extending direction and reciprocally rotating the torsion bars around the rotation axis at the outer coupling position; and
slits formed in the torsion bars such that both ends in the extending direction are closed in a front view as a direction view when the mirror surface is viewed from the one side in the thickness direction and the slits extend along the rotation axis in a length range included between the inner coupling position and the outer coupling position in the extending direction, wherein
a dimension of the torsion bar between both ends in the front view is Wa, and a thickness in the front view is Ta,
a width of the slit in the front view is Wb, and
(Wa - Wb)/Ta < 1 is satisfied.

2. The light deflector according to Claim 1, wherein

a side edge of a first corner portion between a side edge of the torsion bar and a side edge of the actuator in the front view is formed of a first curve line that spreads outside from the side edge of the torsion bar in the width direction and is a convex curve toward an inside of the first corner portion, and
the slit has an outer end portion having a first curved contour shape of which a width in the width direction is wider than the Wb, and formed within an outer coupling region that is set as a region including the outer coupling position inside the region.

3. The light deflector according to Claim 1, wherein

a side edge of a second corner portion between a side edge of the mirror portion and a side edge of the torsion bar in the front view is formed of a second curve line that spreads outside from the side edge of the torsion bar in the width direction and is a convex curve toward an inside of the second corner portion, and
the slit has an inner end portion having a second curved contour shape of which a width in the width direction is wider than the Wb, and formed within an inner coupling region that is set as a region including the inner coupling position inside the region.

4. The light deflector according to Claim 3, wherein

the mirror portion is a circular shape in the front view, and
the second curved contour shape in the front view includes an inner curved contour portion configured to extend in a circular arc concentric with the circular shape, and an outer curved contour portion that is located on a peripheral edge side of the mirror portion with respect to the inner curved contour portion and configured to extend in parallel with the second curve line from both ends of the inner curved contour portion.

5. The light deflector according to Claim 3 or 4, wherein

a side edge of a first corner portion between a side edge of the torsion bar and a side edge of the actuator in the front view is formed of a first curve line that spreads outside from the side edge of the torsion bar in the width direction and is a convex curve toward an inside of the first corner portion, and
the slit has an outer end portion having a first curved contour shape of which a width in the width direction is wider than the Wb, and formed within an outer coupling region that is set as a region including the outer coupling position inside the region.

6. The light deflector according to any one of Claims 1 to 4, wherein the slit extends at an equal width along the rotation axis in the front view, in the length range included between the inner coupling position and the outer coupling position in the extending direction.

7. The light deflector according to any one of Claims 1 to 4, wherein Wa/Ta < 1 is satisfied.

8. The light deflector according to any one of Claims 1 to 4, wherein Wb ≤ 2·Wc is satisfied.

# FIG.1

# FIG.2A

## FIG.2B

## FIG.2C

## FIG.3A

## FIG.3B

## FIG.4

## FIG.5

## FIG.6

# FIG.7

## INTERNATIONAL SEARCH REPORT

International application No.

**PCT/JP2023/033853**

| A. | CLASSIFICATION OF SUBJECT MATTER |
|---|---|

*G02B 26/10*(2006.01)i; *B81B 3/00*(2006.01)i; *G02B 26/08*(2006.01)i; *H10N 30/20*(2023.01)i
FI:    G02B26/10 104Z; G02B26/08 E; B81B3/00; H10N30/20

According to International Patent Classification (IPC) or to both national classification and IPC

| B. | FIELDS SEARCHED |
|---|---|

Minimum documentation searched (classification system followed by classification symbols)

G02B26/10; B81B3/00; G02B26/08

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2020/045152 A1 (PANASONIC INTELLECTUAL PROPERTY MANAGEMENT CO., LTD.) 05 March 2020 (2020-03-05) paragraphs [0015]-[0026], [0048]-[0054], fig. 1, 7 | 1, 6-8 |
| A | paragraphs [0015]-[0026], [0048]-[0054], fig. 1, 7 | 2-5 |
| Y | JP 2012-163939 A (OLYMPUS CORP.) 30 August 2012 (2012-08-30) paragraph [0004] | 1, 6-8 |
| A | JP 2012-63413 A (RICOH CO., LTD.) 29 March 2012 (2012-03-29) paragraphs [0019]-[0032], fig. 1, 2 | 2-5 |
| A | WO 2013/046612 A1 (PANASONIC CORP.) 04 April 2013 (2013-04-04) paragraphs [0012]-[0017], [0044], fig. 1, 2, 11A-11C | 2-5 |

| ☐ Further documents are listed in the continuation of Box C. | ☑ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **14 November 2023** | **28 November 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT
### Information on patent family members

International application No.

**PCT/JP2023/033853**

| Patent document cited in search report | Publication date (day/month/year) | Patent family member(s) | Publication date (day/month/year) |
|---|---|---|---|
| WO 2020/045152 A1 | 05 March 2020 | US 2021/0173201 A1 paragraphs [0024]-[0035], [0057]-[0063], fig. 1, 7 CN 112602000 A | |
| JP 2012-163939 A | 30 August 2012 | US 2013/0301102 A1 paragraph [0006] WO 2012/099112 A1 | |
| JP 2012-63413 A | 29 March 2012 | (Family: none) | |
| WO 2013/046612 A1 | 04 April 2013 | US 2014/0226194 A1 paragraphs [0051]-[0056], [0083], fig. 1, 2, 11A-11C CN 103827725 A | |

Form PCT/ISA/210 (patent family annex) (January 2015)

**EP 4 579 311 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009169290 A
- JP 2016151681 A
- JP 3905539 B
- JP 2012201386 A